Europäisches Patentamt

European Patent Office

Office européen des brevets

(11) Publication number: **0 184 350 B1**

# EUROPEAN PATENT SPECIFICATION

(45) Date of publication of patent specification: **30.01.91**

(21) Application number: **85308403.6**

(22) Date of filing: **19.11.85**

(51) Int. Cl.⁵: **H 03 K 3/037, H 03 K 3/013**

(54) Semiconductor latch circuit.

(30) Priority: **19.11.84 JP 242371/84**
**08.04.85 JP 74085/85**

(43) Date of publication of application:
**11.06.86 Bulletin 86/24**

(45) Publication of the grant of the patent:
**30.01.91 Bulletin 91/05**

(84) Designated Contracting States:
**DE FR GB**

(56) References cited:
**EP-A-0 045 403**
**US-A-3 786 282**
**US-A-4 048 521**

**PATENT ABSTRACTS OF JAPAN, vol. 5, no. 59
(E-53)731r, 22nd April 1981; & JP - A - 56 10735
(MITSUBISHI DENKI K.K.) 03-02-1981**

**IBM TECHNICAL DISCLOSURE BULLETIN, vol.
24, no. 12, May 1982; pages 6461-6462, New
York, US; D.B. EARDLEY "Latch circuit
insensitive to disturb by alpha particles"**

(73) Proprietor: **FUJITSU LIMITED**
**1015, Kamikodanaka Nakahara-ku
Kawasaki-shi Kanagawa 211 (JP)**

(72) Inventor: **Kanai, Yasunori**
**2-401, 536-5, Oomaru
Inagi-shi Tokyo 206 (JP)**
Inventor: **Nawata, Kazumasa**
**5-22-32-204, Nishiikuta Tama-ku
Kawasaki-shi Kanagawa 214 (JP)**
Inventor: **Shimizu, Mitsuhisa**
**Inoueso 2-A, 5-5-5, Suge Tama-ku
Kawasaki-shi Kanagawa 214 (JP)**
Inventor: **Yada, Hiroki**
**1-12-33, Edanishi Midori-ku
Yokohama-shi Kanagawa 227 (JP)**
Inventor: **Saitoh, Taichi**
**Fujitsu Aobadai-ryo 54-10, Shiratoridai
Midori-ku Yokohama-shi Kanagawa 227 (JP)**
Inventor: **Sakai, Toshiaki**
**Fujitsu Kuwana-ryo, 221 Horie-cho
Higashikata Kuwana-shi Mie 511 (JP)**

(74) Representative: **Billington, Lawrence Emlyn
et al
HASELTINE LAKE & CO Hazlitt House 28
Southampton Buildings Chancery Lane
London WC2A 1AT (GB)**

**EP 0 184 350 B1**

56 References cited:

PATENT ABSTRACTS OF JAPAN, vol.7, no. 49
(E-161)(1194), 25th February 1983, & JP-A-
57199318

## Description

The present invention relates to a semiconductor integrated circuit. More particularly, it relates to a latch circuit.

In charge-coupled-device (CCD) memories and dynamic metal oxide semiconductor (MOS) randam access memories (RAMs), soft-errors due to alpha-rays are widely experienced. A package for a semiconductor device may include very small amounts of uranium (U) and thorium (Th) which decay and emit alpha-rays. The emitted alpha-rays impinge on a semiconductor chip including integrated circuits and generate a plurality of pairs of electrons and positive-holes, particularly at capacitors or depletion regions. The electrons are gathered to an active region, such as a collector region of a transistor, resulting in a reduction of potential at the collector. This reduction of potential occurs only for a very short period, for example, several hundreds of pico-seconds, but may adversely affect the integrated circuit in the semiconductor chip.

In principle, such a soft-error may occur in any semiconductor device. In dynamic MOS RAMs, for example, to overcome soft-errors, countermeasures are taken such as the provision of error-collection circuits (ECCs), alpha-ray shield sheets, etc.

In bipolar semiconductor devices or static MOS RAMs, such soft-errors have not had a serious effect in the past, because these devices have high stability of operation and relatively large signal amplitudes. Recently, however, the integration of semiconductor devices has greatly increased, resulting in small amplitudes and small operation currents. As a result, even in bipolar semiconductor devices including, for example, emitter-coupled logic (ECL) circuits and transistor-transistor logic (TTL) circuits, the effects of soft-errors must be taken into account.

Latch circuits are extensively used in semiconductor devices. For example, in a gate array semiconductor device, latch circuits are used for holding input or output data or temporary internal data storage, or the like. In a memory device, latch circuits are used for holding control data, or the like. If latch circuits are affected by soft-error, the held data may be destroyed, causing troublesome problems such as error signal output. Therefore, latch circuits of the bipolar type or other type must be protected from the effects of alpha-rays.

Known circuits for overcoming soft-errors, however, cannot be applied to latch circuits, because latch circuits must maintain high speed response and must have a simple structure.

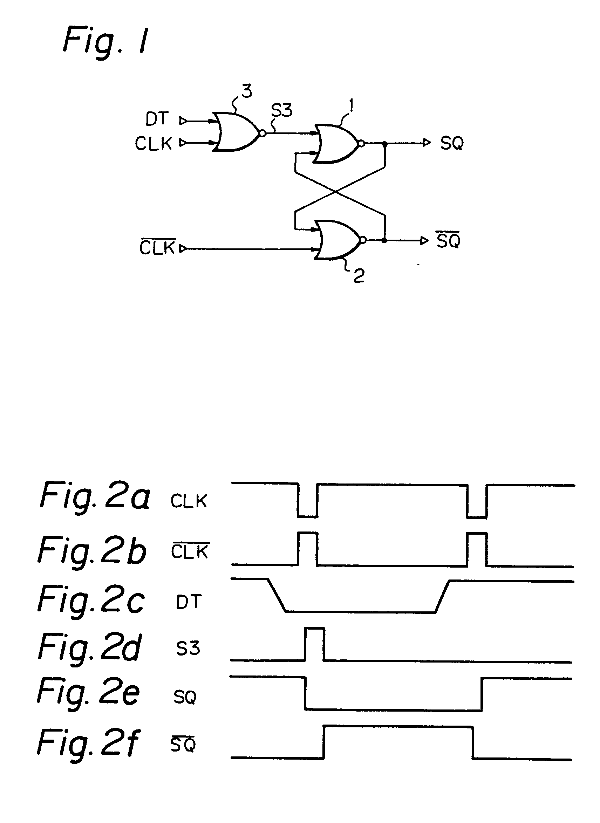

JP—A—57 199 318 discloses a bipolar data latch formed by three NOR gates in an arrangement similar to that shown in Figure 1 of the accompanying drawings.

US—A—4 048 521 discloses a set-reset flip-flop having two cross-connected NAND gates and an internal resistor-capacitor circuit. The resistor-capacitor circuit is incorporated in the non-inverted output side of the flip-flop and acts to prevent pulses of relatively short duration, due to random noise, from changing the output state of the device. However, the output response of the non-inverted output side of the flip-flop is worsened.

According to a first aspect of the present invention, there is provided a latch circuit, comprising at least two gate circuits with feedback lines connecting outputs and inputs thereof, and noise resistance means connected to one of said feedback lines; characterised by the following structure:—

a first gate circuit operatively connected to receive a data signal and a clock signal and having an output terminal;

a second gate circuit having a first input terminal operatively connected to the output terminal of said first gate circuit, having a second input terminal and having an output terminal,

a third gate circuit having a first input terminal operatively connected to receive an inverted clock signal at an input terminal and a second input terminal and having first and second output terminals;

a first feedback line connected between the output terminal of said second gate circuit and the second input terminal of said third gate circuit;

a second feedback line connected between the first output terminal of said third gate circuit and the second input terminal of said second gate circuit, the second output terminal of said third gate circuit and the output terminal of said second gate circuit outputting complementary signals in response to a latched state of said latch circuit; and

noise resistance means, operatively connected to only said second feedback line and including at least a signal delay element, for eliminating noise in said second feedback line and maintaining operation speed of said latch circuit.

According to a second aspect of the present invention, there is provided a latch circuit, comprising at least two gate circuits with feedback lines connecting outputs and inputs thereof, and noise resistance means connected to one of said feedback lines; characterised by the following structure:—

a first OR gate circuit operatively connected to receive a data signal and a clock signal, and having a non-inverted output terminal and an inverted output terminal;

a second OR gate circuit having a first input terminal operatively connected to receive an inverted clock signal and having a second input terminal, a non-inverted output terminal, and an inverted output terminal;

an AND gate circuit having first and second input terminals and having first and second output terminals;

a wired OR gate circuit having first and second input terminals, said non-inverted output terminal of

3

said first OR gate circuit operatively connected to the first input terminal of said AND gate circuit, and said inverted output terminal of said first OR gate circuit operatively connected to the first input terminal of said wired OR gate circuit, said inverted output terminal of said second OR gate circuit operatively connected to the second input terminal of said wired OR gate circuit, and said non-inverted output terminal of said second OR gate circuit operatively connected to the second input terminal of said AND gate circuit, an output terminal of said wired OR gate circuit and the first output terminal of said AND gate circuit outputting complementary signals;

a feedback line connected between the second output terminal of said AND gate circuit and the second input terminal of said second OR gate circuit; and

noise resistance means, operatively connected to said feedback line; including at least a signal delay element.

According to a third aspect of the present invention, there is provided a latch circuit, comprising at least two gate circuits with feedback lines connecting outputs and inputs thereof, and noise resistance means connected to one of said feedback lines; characterised by the following structure:—

a first gate circuit operatively connected to receive a data signal and a clock signal and having an output terminal;

a second gate circuit having a first input terminal operatively connected to said output terminal of said first gate circuit and having a second input terminal, and having first and second output terminals;

a third gate circuit having first and second input terminals and having first and second output terminals;

a first feedback line connected between said second output terminal of said second gate circuit and said second input terminal of said third gate circuit;

a second feedback line connected between said first output terminal of said third gate circuit and said second input terminal of said second gate circuit; and

noise resistance means, operatively connected to only said first feedback line, inlcuding at least a signal delay element, for eliminating noise in said first feedback line and maintaining operation speed of said latch circuit.

An embodiment of the present invention may provide a latch circuit having a noise resistance and maintaining a high speed response.

An embodiment of the present invention may provide a latch circuit having a noise resistance circuit formed by a simple structure.

An embodiment of the present invention may provide a latch circuit having the above advantages in a semiconductor device.

The noise resistance circuit may include a filter circuit. The filter circuit may be a resistor-capacitor connected filter. The noise resistance circuit may include an amplifier circuit having a signal delaying element for a predetermined time and a signal amplifying element for a predetermined amplification. The amplifier circuit may include a differential amplifier formed by transistors.

Reference is made, by way of example, to the accompanying drawings, in which:

Fig. 1 is a block diagram of a known latch circuit;

Figs. 2a to 2f are timing charts of the latch circuit shown in Fig. 1;

Fig. 3 is a circuit diagram of the latch circuit shown in Fig. 1;

Fig. 4 is a sectional view of a bipolar transistor in the latch circuit shown in Fig. 1, for explaining the occurrence of soft errors;

Fig. 5 is a block diagram of a latch circuit of an embodiment according to the present invention;

Fig. 6 is a circuit diagram of the latch circuit shown in Fig. 5;

Figs. 7 and 8 are sectional views of resistors and capacitors in the latch circuit shown in Fig. 6;

Fig. 9 is a block diagram of a latch circuit of another embodiment according to the present invention;

Fig. 10 is a circuit diagram of the latch circuit shown in Fig. 9;

Fig. 11 is a block diagram of a latch circuit in still another embodiment according to the present invention;

Fig. 12 is a circuit diagram of the latch circuit shown in Fig. 11;

Fig. 13 is a block diagram of a latch circuit in yet another embodiment according to the present invention; and,

Fig. 14 is a circuit diagram of the latch circuit shown in Fig. 13.

Before describing preferred embodiments of the present invention, an explanation will be given of a known latch circuit.

Referring to Fig. 1, a known latch circuit includes three NOR gate circuits 1 to 3. Each output of the NOR gate circuits 1 and 2 is fed back to an input of the other NOR gate circuit. The NOR gate circuit 3 receives an input data DT and a clock pulse CLK and an output thereof is connected to another input of the NOR gate circuit 1. An inverted clock pulse $\overline{CLK}$ is supplied to another input of the NOR gate circuit 2.

Referring to Figs. 2a to 2f, the operation of the latch circuit in Fig. 1 will be described. When the input data DT is low level at the time the clock pulse CLK is changed to low level, a signal S3 at the output of the NOR gate circuit 3 becomes high level. At this time, if an output signal SQ of the NOR gate circuit 1 is high level as an initial condition, the output signal SQ is changed to low level. Accordingly, at the time the inverted clock pulse $\overline{CLK}$ is changed from high level to low level, two inputs at the NOR gate circuit 2 are both low level, with the result that an output signal $\overline{SQ}$ of the NOR gate circuit 2 is changed to high level. If one input of the NOR gate circuit 3 is maintained at high level, and after the output signal S3 of the NOR gate circuit 3 changes from high level to low level, the output signal SQ of the NOR gate circuit 1 is maintained at low level.

When the input data DT is high level at the time the clock pulse CLK is changed from high level to low level, the output signal S3 of the NOR gate circuit 3 is maintained at low level. When the inverted clock pulse $\overline{CLK}$ is changed from low level to high level, the output signal $\overline{SQ}$ of the NOR gate circuit 2 is rendered to low level, thus changing the output signal SQ of the NOR gate circuit 1 to high level. After the inverted clock pulse $\overline{CLK}$ is changed from high level to low level, the input signal at the NOR gate circuit 2 is kept at high level by applying the high level output signal SQ, and thus the output signal $\overline{SQ}$ is maintained at low level.

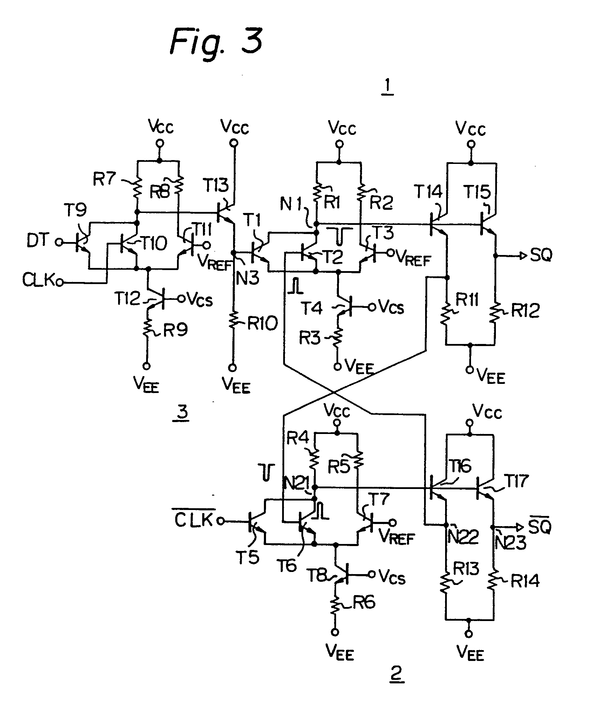

Fig. 3 is an ECL gate circuit diagram of the latch circuit shown in Fig. 1. In Figs. 1 and 3, the NOR gate circuit 1 is formed by transistors T1, T2, T3, and T4 and cooperative resistors R1, R2, R3. Namely, the resistors R1 and R2 and the transistors T1 to T3 form an ECL gate and the series-connected transistor T4 and the resistor R3 form a current source. The NOR gate circuit 2 is formed by transistors T5, T6, T7, and T8 and resistors R4, R5, and R6. Namely, the resistors R4 and R5 and the transistors T5 to T7 form an ECL gate and the transistor T8 and the resistor R6 form a current source. The NOR gate circuit 3 is formed by transistors T9, T10, T11, and T12 and resistors R7, R8, and R9. Namely, the resistors R7 and R8 and the transistors T9 to T11 form an ECL gate and the transistor T12 and the resistor R9 form a current source. The output of the NOR gate circuit 3 is connected to an input of the NOR gate circuit 1, i.e., base of the transistor T1, through an emitter follower circuit formed by a series-connected transistor T13 and a resistor R10. An output of the NOR gate circuit 1 is transmitted as the output signal SQ through an emitter follower circuit formed by a series-connected transistor T15 and a resistor R12. Another output of the NOR gate circuit 1 is supplied to one input of the NOR gate circuit 2, i.e., a base of the transistor T6, through an emitter follower circuit formed by a series-connected transitor T14 and a resistor R11. An output of the NOR gate circuit 2 is extracted as the output signal $\overline{SQ}$ through an emitter follower circuit formed by a series-connected transistor T17 and a resistor R14. Another output of the NOR gate circuit 2 is supplied to another input of the NOR gate circuit 1, i.e., a base of the transistor T2, through an emitter follower circuit formed by a series-connected transistor T16 and a resistor R13.

The NOR gate circuit 3 receives the input data DT at an input terminal, i.e., a base of the transistor T9, and the clock pulse CLK at another input terminal, i.e., a base of the transistor T10. When the input data DT and the clock pulse CLK are low level, the transistors T9 and T10 are turned OFF, thus making the transistor T11 ON. As a result, the output of the NOR gate circuit 3 connected to a base of the transistor T13 becomes high level. Conversely, when at least one of the input data DT and the clock pulse CLK is high level, one of the transistors T9 and T10 is turned ON, thus making the transistor T11 OFF. As a result, the output of the NOR gate circuit 3 is rendered to low level.

The above operation of the NOR gate circuit 3 can be applied to the NOR gate circuits 1 and 2 in a similar way. Accordingly, the circuit shown in Fig. 3 performs a latch operation set forth above with reference to Figs. 1 and 2a to 2f.

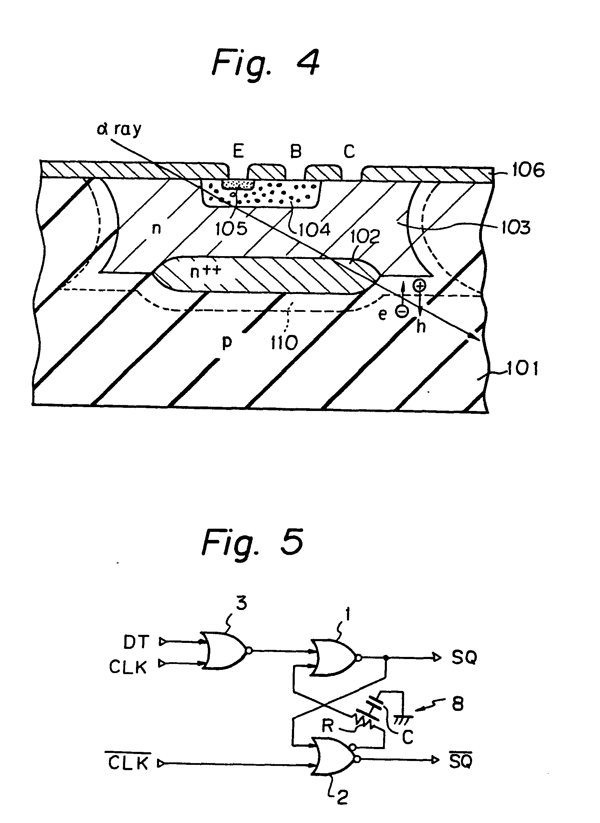

Referring to Fig. 4, a soft-error in a bipolar transistor, for example, the transistor T2 in Fig. 3, will be described. The transistor is for example formed by a p-type silicon substrate 101, $n^{++}$ implanted layer 102, n-type epitaxial growth layer 103, a first diffused layer 104, a second diffused layer 105, and an insulation layer 106 of $SiO_2$. An emitter E, a base B, and a collector C are connected to the exterior through contact windows formed in the insulation layer 106. Along a boundary face formed between the substrate 101, the epitaxial growth layer 103, and the implanted layer 102, a depletion layer 110, as shown by dotted lines, forms a parasite capacitor.

The materials used for a package of a semiconductor device may include a small quantity of Uranium and/or Thorium, which emit alpha rays. When alpha rays emitted from the package pass through the depletion layer 110, as shown in Fig. 4, a plurality of carriers, each of which consists of a pair of an electron e and a positive hole h, may be generated at the depletion layer 110. The electrons e are gathered to an active region, i.e., a collector region in the example, while the positive holes h drop to the substrate 101. Alpha ray energy is approximately 5 MeV on average and approximately 9 MeV at maximum. An alpha ray having an energy of 5 MeV will penetrate approximately 30 μm into silicon, resulting in the generation of approximately $1.4 \times 10^6$ pairs of electrons and positive holes. If $1.4 \times 10^6$ electrons are gathered to the collector region during a period of 0.1 to 1 ns, an approximately 200 μA pulse current may flow into the collector region. If the gathering time is short, the pulse current may be increased. The charge Q is defined by the product of a capacitance C of the parasite capacitance and a potential V, i.e., $Q = C \cdot V$. By increasing the integration of the semiconductor circuits, the area of each depletion region is reduced resulting in a small parasitic capacitance. When the charge Q is a constant, the potential V is increased due to reduction of the capacitance C. As a result, even in a bipolar integrated semiconductor device the potential change due to the pulse current caused by alpha rays may result in a malfunction of the transistor.

Referring back to Fig. 3, suppose that high level data of the output signal SQ and low level data of the output signal $\overline{SQ}$ are held. At this time, the transistors T1 and T2 in the NOR gate circuit 1 are turned OFF, and thus a node N1 is made high level. The transistor T6 in the NOR gate circuit 2 is turned ON, and thus a node N21 is made low level. Under this condition, if a negative polarity noise pulse due to alpha rays is supplied to the node N1, the noise pulse is supplied to the base of the transistor T6 through the transistor T14, with the result that the transistor T6 is made OFF for a short period. At this time, a positive polarity noise pulse may be generated at the node N21. The latter noise pulse is fed back to the base of the transistor T2, with a resultant that the potential at the node N1 is further reduced to low level. As a result, data storage in the latch circuit may be destroyed.

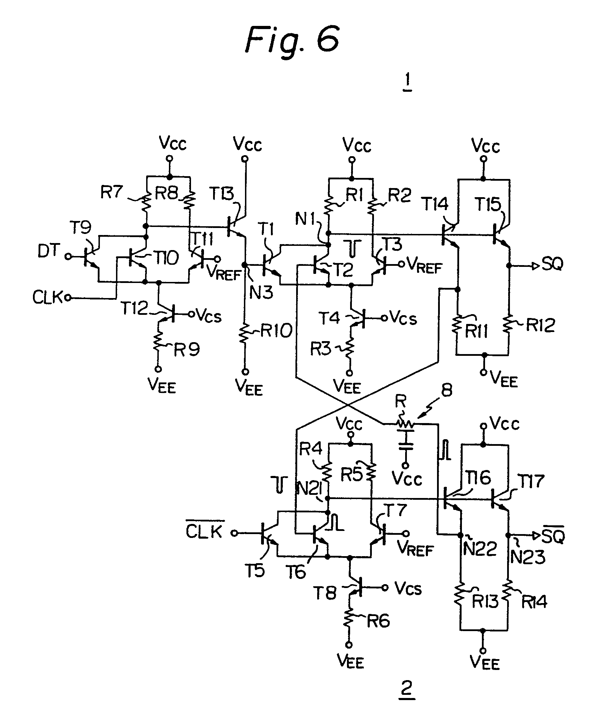

Referring to Figs. 5 and 6, an embodiment of the present invention will be described.

In Fig. 5, a latch circuit further includes a low pass filter (LPF) circuit 8 in addition to NOR gate circuits 1, 2, and 3 which correspond to those in Fig. 1. Preferably, the LPF circuit 8 is provided in a final stage feedback line, i.e., a line between an output of the NOR gate circuit 2 and an input of the NOR gate circuit 1, from the data input side at the NOR gate circuit 3. The input signals DT and CLK at the NOR gate circuit 3 propagate a path defined by the NOR gate circuit 3, the NOR gate circuit 1, and the NOR gate circuit 2 for outputting the output signals SQ and $\overline{SQ}$ in response to the input data, while the input signals at the NOR gate circuit 2 propagate another path defined by the NOR gate circuit 2 and the NOR gate circuit 1. The former path has a longer signal transmission length than that of the latter path. If the LPF circuit 8 is provided in another feedback line, i.e., a line between the output of the NOR gate circuit 1 and the input of the NOR gate circuit 2, in the former path, a response outputting the output signal SQ may be retarded due to a time delay of a signal in the LPF circuit 8. On the contrary, when the LPF circuit 8 is provided in the final stage feedback line, as shown in Fig. 5, the response outputting the output signals SQ and $\overline{SQ}$ is not substantially affected. This is advantageous for maintaining a high speed operation of the latch circuit.

The LPF circuit 8 consists of a resistor R and a capacitor C and functions as a noise filter for suppressing the above noise.

Fig. 6 is a detailed circuit diagram of the latch circuit shown in Fig. 5. The circuit shown in Fig. 6 corresponds to the circuit shown in Fig. 3, thus the NOR gate circuits 1, 2, and 3 are similar to those shown in Fig. 3. In Fig. 6, the LPF circuit 8 is provided in a feedback line between a node N22 and a base of the transistor T2.

Example circuit parameters are as follows:

| | |
|---|---|
| Resistance for the ECL gate resistors R1, R2, R4, R5, R7, and R8 | 2.5 kΩ |
| Resistance for the current source resistors R3, R6, and R9 | 0.75 kΩ |
| Resistance for the emitter-follower circuit resistors R10, R11, R12, R13, and R14 | 1 kΩ |
| Voltage of $V_{cc}$ | Ground |
| Voltage of $V_{cs}$ | −2.9 V |
| Voltage of $V_{EE}$ | −5.2 V |
| Voltage of $V_{REF}$ | −1.1 V |
| Voltage of the external signals | DT, CLK, $\overline{CLK}$ |
| High level | −0.85 V |
| Low level | −1.35 V |

As can be seen from the above, a current flowing in the ECL gate, for example, the resistor R2 and the transistor T3, may be 0.2 mA and a voltage of a collector of the transistor T3 may be −0.5 V, which may be affected by the noise of the alpha-rays. A time constant of the LPF cicuit 8 is for example approximately 200 pico-seconds.

The normal operation of the circuit shown in Fig. 6 is similar to that of the circuit shown in Fig. 3, and thus description thereof is omitted.

Suppose in the latch circuit shown in Fig. 6 a high level of the output signal SQ is held, as mentioned above, and a negative polarity noise pulse due to alpha rays is applied to the node N1, the noise pulse being propagated to the base of the transistor T6 through the transistor T14. The transistor T6 is turned OFF for a short period, generating a short period polarity noise pulse at the node N21. The latter noise pulse may turn the transistors T16 and T17 ON, generating short period polarity pulses at the nodes N22 and N23. The pulse at the node N22 is delayed and suppressed in the LPF circuit 8, and thus is not supplied to the base of the transistor T2. Accordingly, the data (SQ) held in the latch circuit is maintained. Upon receipt of the negative polarity noise pulse at the node N1, the output signal SQ may fall, but will be rapidly recovered.

In normal operation, a feedback signal from the node N22 to the base of the transistor T2, which has a longer pulse width than that of the noise pulse, is retarded by a predetermined time defined by a time constant of the LPF circuit 8. This does not substantially effect an adverse response time of the latch circuit, as discussed above with reference to Fig. 5.

In Fig. 6, the NOR gate circuit 2 includes two emitter follower circuits, one of which comprises the transistor T16 and the resistor R13, and the other comprises the transistor T17 and the resistor R14. By separating the output node N23 for the output signal $\overline{SQ}$ from the output node N22 for the feedback signal, the output response time of the output signal $\overline{SQ}$ is kept free from the delay on the feedback line including the LPF circuit 8.

6

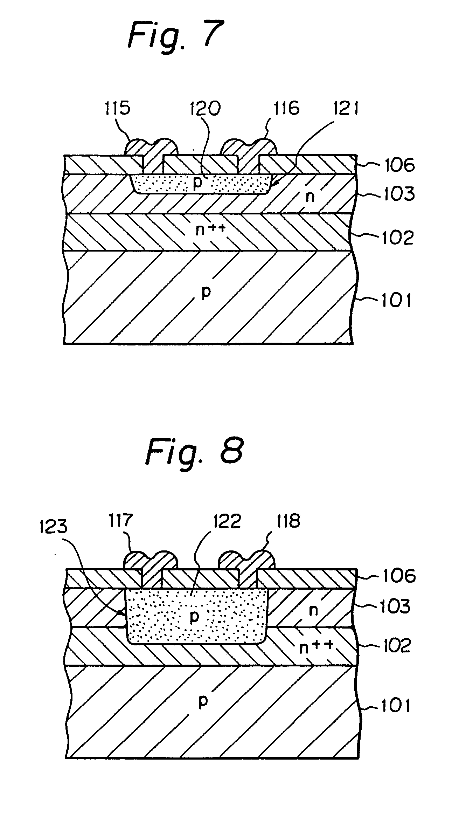

The LPF circuit 8 may be formed in a variety of ways, some examples of which will be described with reference to Figs. 7 and 8.

In Fig. 7, a resistor region 120 is normally diffused in the epitaxial growth layer 103 and the opposite ends thereof are connected to electrodes 115 and 116 through contact windows formed in the insulation layer 106. A capacitor forming a part of the LPF circuit 8 is formed in a depletion layer 121, which is formed along a face of the resistor region 120 and the epitaxial growth layer 103.

In Fig. 8, a resistor region 122 is formed in the epitaxial growth layer 103 and the implanted layer 102 by an isolation diffusion and an implanted layer process. Opposite ends of the resistor region 122 are connected to electrodes 117 and 118 through contact windows formed in the insulation layer 106. A capacitor is formed in a depletion layer 123, which is formed along a face of the resistor region 122 and the epitaxial growth and implanted layers 103 and 102. The capacitor has a greater capacitance than that of Fig. 7.

The resistance of the resistor region 120 or 122 and capacitance of the capacitor in the depletion layer 121 or 123 are suitably designed to eliminate alpha-ray noise. For example, in Fig. 7, the resistance may be approximately 2 k$\Omega$ and the capacitance approximately 0.1 pF, giving a time constant of approximately 200 ps, and in Fig. 8, the resistance is for example approximately 500 $\Omega$ and the capacitance 1 pF, thus the time constant is approximately 500 ps.

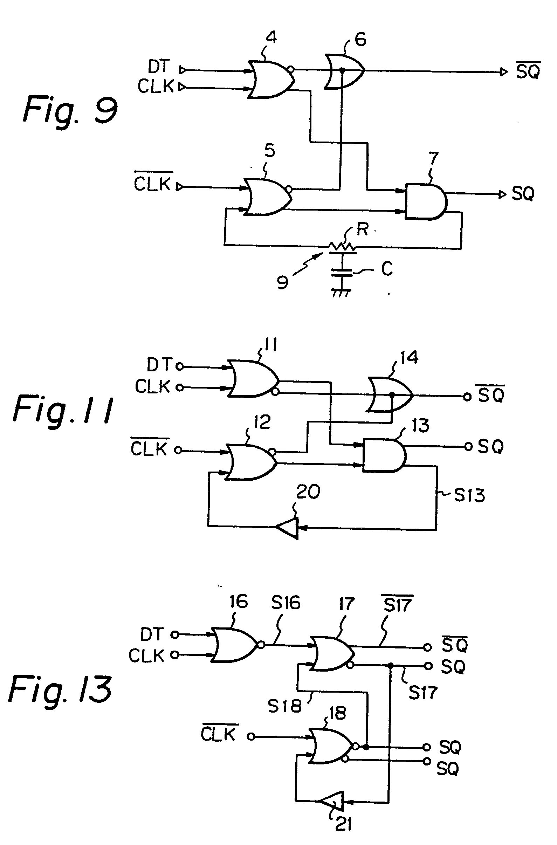

Referring to Fig. 9, another embodiment of the present invention will be described.

In Fig. 9, a latch circuit includes an OR gate circuit 4 receiving input data DT and a clock pulse CLK and having inverted and non-inverted output terminals, an OR gate circuit 5 receiving an inverted clock signal $\overline{CLK}$ and having inverted and non-inverted output terminals, a wired-OR gate (AND gate) circuit 6 outputting an inverted output signal $\overline{SQ}$, and an AND gate circuit 7 outputting an output signal SQ. The non-inverted output terminals of the OR gate circuits 4 and 5 are connected to input terminals of the AND gate circuit 7. The inverted output terminals of the OR gate circuits 4 and 5 are connected to the OR gate circuit 6. A low-pass-filter (LPF) circuit 9 is provided in a feedback line from an output terminal of the AND gate circuit 7 to an input terminal of the OR gate circuit 5.

When the input data DT is low level, and the clock pulse CLK is changed from high level to low level, a low level output signal SQ is output from the AND gate circuit 7. The low level output at the AND gate circuit 7 is fed back to the input of the OR gate circuit 5 through the LPF circuit 9. After the inverted clock pulse $\overline{CLK}$ is changed to low level, the non-inverted output of the OR gate circuit 5 becomes low level, maintaining the output of the AND gate circuit 7 at low level and the inverted output of the OR gate circuit 5 is high level, thus the output signal $\overline{SQ}$ is maintained at high level. If, when the input data DT is high level, the clock pulse CLK is changed from high level to low level, accordingly the non-inverted output of the OR gate circuit 4 becomes high level. At this time, the inverted clock pulse $\overline{CLK}$ is changed from low level to high level, with the result that the non-inverted output of the OR gate circuit 5 is made high level. As a result, the outputs of the AND gate circuit 7 become high level. The high level output of the AND gate circuit 7 is fed back to the input of the OR gate circuit 5 through the LPF circuit 9, to hold the output signal SQ at high level.

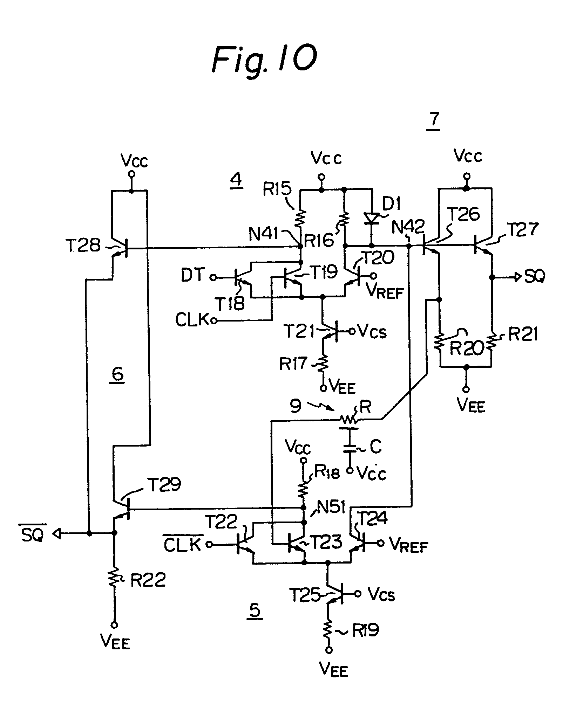

The latch circuit shown in Fig. 9 can be realized by a circuit shown in Fig. 10, as an example of an ECL gate circuit. In Fig. 10, the OR gate circuit 4 includes transistors T18, T19, T20, and T21, a diode D1, and resistors R15, R16, and R17. The OR gate circuit 5 includes transistors T22, T23, T24, and T25 and resistors R18 and R19. At a node N42, a collector of the transistor T20 and a collector of the transistor T24 are common-connected to form the wired-AND gate circuit 7. The AND gate circuit 7 includes two emitter follower circuits, consisting respectively of transistors T26, T27 and resistors R20 and R21. One of these is used for outputting the signal SQ unaffected by the LPF circuit 9, and other is used to feed back the signal to a base of the transistor T23. In the feedback line, the LPF circuit 9 is provided on the basis of avoiding a retardation of the circuit response, set forth above. The OR gate circuit 6 includes transistors T28 and T29 and a resistor R22 and outputs the output signal $\overline{SQ}$. The input data DT is supplied to a base of the transistor T18. The clock pulse $\overline{CLK}$ is supplied to a base of the transistor T19. The inverted clock pulse $\overline{CLK}$ is supplied to a base of the transistor T22.

The circuit parameters in Fig. 10 are applied in the same way as in Fig. 6, as mentioned above.

In Fig. 10, if a noise pulse due to alpha rays is supplied to a node N42 under the latch circuit holding the output SQ at high level, the noise pulse through the transistor T6 is eliminated at the LPF circuit 9, and thus is not transmitted to the OR gate circuit 5.

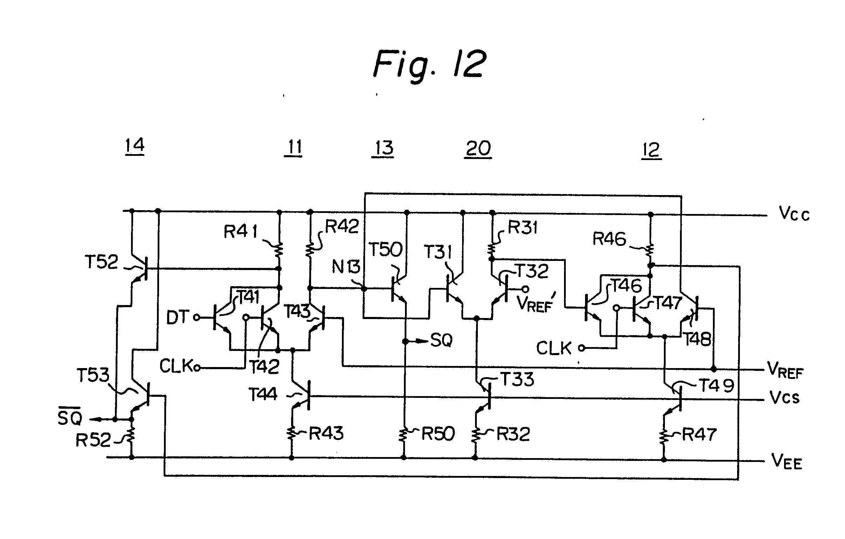

Referring to Fig. 11, still another embodiment of the present invention will be described.

A latch circuit includes an OR gate circuit 11 receiving an input data DT and a clock signal CLK and having an inverted output terminal and a non-inverted terminal, an OR gate circuit 12 receiving an inverted clock signal $\overline{CLK}$ and having an inverted output terminal, an AND gate circuit 13 outputting a non-inverted output signal SQ, and a wired-OR gate circuit 14 outputting an inverted output signal $\overline{SQ}$. The non-inverted output terminals of the OR gate circuits 11 and 12 are connected to input terminals of the AND gate circuit 13. The inverted output terminals of the OR gate circuits 11 and 12 are connected to the wired-OR (AND) gate circuit 14. An amplifier 20, such as a differential amplifier, is provided in a feedback line from the output terminal of the AND gate circuit 13 to an input terminal of the OR gate circuit 12. The amplifier circuit 20 delays an input signal by a predetermined period defined by a gate element therein and amplifies the input signal to a predetermined level.

7

The latch circuit shown in Fig. 11 is similar to that shown in Fig. 9, except for the provision of the LPF circuit 9 in Fig. 9 and the amplifier circuit 20 in Fig. 11. The basic operation of the latch circuit in Fig. 11 is thus similar to that of the latch circuit shown in Fig. 9.

When a noise pulse due to alpha rays is applied to the latch circuit, the noise pulse is delayed at the gate element in the amplifier circuit 20 and an output signal S13 having the noise pulse superimposed is also amplified in the amplifier circuit 20. A noise pulse having a very short pulse width may be suppressed at the gate element. Another noise pulse having a wider pulse width is amplified to a predetermined level higher than a threshold level of the gate trigger of the OR gate circuit 12.

Referring to Fig. 12, the latch circuit in Fig. 11 will be specifically described. In Fig. 12, the OR gate circuit 11 includes gate transistors T41 to T43, resistors R41 and R42, and a current source of a transistor T44 and a resistor R43. The OR gate circuit 12 includes gate transistors T46 to T48, a resistor R46 and a current source of a transistor T49 and a resistor R47. A collector of the transistor T43 and a collector of the transistor R48 are common-connected at a node N13 to form the wired-AND gate circuit 13. The wired-AND gate circuit 13 includes an emitter follower circuit of a transistor T50 and a resistor R50, for outputting the non-inverted output signal SQ. The OR gate circuit 14 includes parallel-connected transistors T52 and T53 and a resistor R52, and outputs the inverted output signal $\overline{SQ}$. The amplifier circuit 20 includes a differential amplifier consisting of transistors T31 and T32 and a resistor R31 and a current source consisting of a transistor T33 and a resistor R32.

The input data DT is supplied to a base of the transistor T41. The (inverted) clock pulse $\overline{CLK}$ is supplied to a base of the transistor T42. The (non) inverted clock pulse CLK is supplied to a base of the transistor T47. A base of the transistor T31 is connected to the node N13. A collector of the transistor T32 is connected to a base of the transistor T46.

When a negative polarity noise pulse due to alpha rays appears at the collector of the transistor T43, the noise pulse is supplied to the base of the transistor T31. If the noise pulse has a very short pulse width, it may be reduced by the transistors T31 and T32 having gate delay characteristics, but a noise pulse having a wide pulse width is not eliminated by the transistors T31 and T32. The signal including the noise pulse applied to the amplifier is amplified over a threshold level of the transistor T46. Accordingly, the transistor T46 is not turned OFF even for a short period, maintaining the held state.

An amplification factor of the amplifier may be adjusted by changing the resistance of the resistor R31. The output level of the collector of the transistor T32 may be set approximately as two fold that of the input data DT or other signals.

An example of circuit parameters in the latch circuit shown in Fig. 11 is shown as follows:

| | |
|---|---|
| Resistance of the resistors R41, R42, and R46 | 2.5 kΩ |
| Resistance of the resistors R43 and R47 | 0.75 kΩ |
| Resistance of the resistors R50 and R52 | 1 kΩ |
| Resistance of the resistor R31 | 5 kΩ |
| Resistance of the resistor R32 | 0.75 kΩ |
| Voltage of $V_{REF}'$ | −1.1 V |

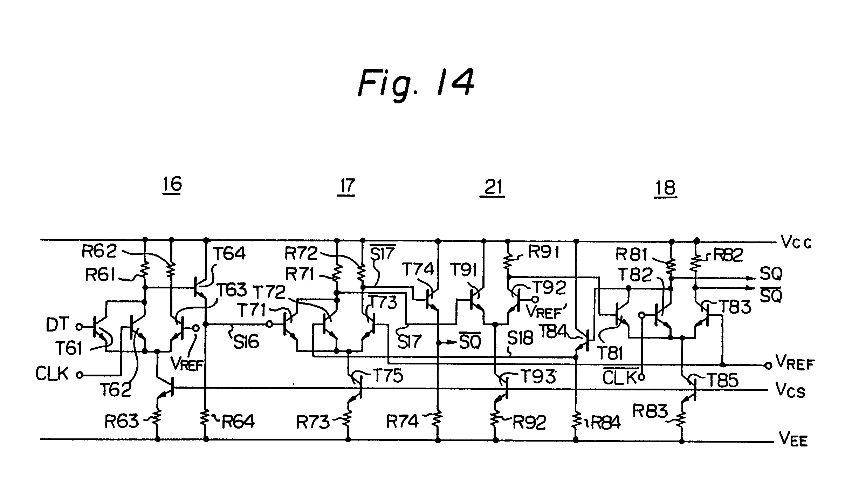

Referring to Fig. 13, yet another embodiment of the present invention will be described.

The latch circuit in Fig. 13 is the same type of latch circuit as shown in Figs. 1 and 5. The latch circuit includes a NOR gate circuit 16 receiving an input data DT and a clock signal CLK, a NOR gate circuit 17, and a NOR gate circuit 18 receiving an inverted clock signal $\overline{CLK}$. An amplifier circuit 21 is provided in a feedback line between an output of the NOR gate circuit 17 and an input of the NOR gate circuit 18. The NOR gate circuit 17 may be replaced by an OR gate circuit having inverted output and non-inverted output terminals.

Fig. 14 is a specific circuit diagram of the latch circuit shown in Fig. 13. In Fig. 14, the NOR gate circuits 16 to 18 are similar to the detailed circuits shown in Fig. 6. However, in order to simplify the drawing, one emitter follower circuit in the respective NOR gate circuits 17 and 18 is omitted from the drawing. The amplifier circuit 21 is similar to the circuit configuration shown in Fig. 12.

The latch circuits having noise resistance circuits, i.e., the LPF circuits 8, 9 and/or the amplifier circuits 20, 21, may (thereby) have a resistance against normal external noises, such as high-frequency noises, noises from power sources, etc.

Latch circuits in accordance with the present invention can be applied not only to other bipolar-type integrated circuits, for example, TTL circuits, but also to metal-insulation-semiconductor (MIS) integrated circuits, for example, static and dynamic RAMs, and other semiconductor devices.

The latch circuits of the present invention may be used in a variety of applications, such as gate array devices, memory devices, etc.

The latch circuits of the present invention can be also applied not only to a semiconductor device, but also to other logic circuits.

A noise resistance circuit employed in embodiments of the present invention may be provided in a number of ways, for example by a filter circuit, an amplifier circuit, or a combination of these.

**Claims**

1. A latch circuit, comprising at least two gate circuits with feedback lines connecting outputs and inputs thereof, and noise resistance means connected to one of said feedback lines; characterised by the following structure:—

a first gate circuit (3) operatively connected to receive a data signal and a clock signal and having an output terminal;

a second gate circuit (1) having a first input terminal operatively connected to the output terminal of said first gate circuit, having a second input terminal and having an output terminal;

a third gate circuit (2) having a first input terminal operatively connected to receive an inverted clock signal at an input terminal and a second input terminal and having first and second output terminals;

a first feedback line connected between the output terminal of said second gate circuit (1) and the second input terminal of said third gate circuit (2);

a second feedback line connected between the first output terminal of said third gate circuit (2) and the second input terminal of said second gate circuit (1), the second output terminal of said third gate circuit (2) and the output terminal of said second gate circuit (1) outputting complementary signals in response to a latched state of said latch circuit; and

noise resistance means (8), operatively connected to only said second feedback line and including at least a signal delay element, for eliminating noise in said second feedback line and maintaining operation speed of said latch circuit.

2. A latch circuit according to claim 1, wherein said first, second and third gate circuits (1, 2, 3) are NOR gate circuits and said feedback line is formed between an output terminal of said third NOR gate circuit (2) and an input terminal of said second NOR gate circuit (1).

3. A latch circuit according to claim 2, wherein said third NOR gate circuit (2) has first and second output terminals, the first output terminal being operatively connected to the input terminal of said second NOR gate circuit (1) and the second output terminal outputting a signal in response to a latched state of said latch circuit.

4. A latch circuit, comprising at least two gate circuits with feedback lines connecting outputs and inputs thereof, and noise resistance means connected to one of said feedback lines; characterised by the following structure:—

a first OR gate circuit (4, 11), operatively connected to receive a data signal and a clock signal, and having a non-inverted output terminal and an inverted output terminal;

a second OR gate circuit (5, 12) having a first input terminal operatively connected to receive an inverted clock signal and having a second input terminal, a non-inverted output terminal, and an inverted output terminal;

an AND gate circuit (7, 13) having first and second input terminals and having first and second output terminals;

a wired OR gate circuit (6, 14) having first and second input terminals, said non-inverted output terminal of said first OR gate circuit (4, 11) operatively connected to the first input terminal of said AND gate circuit (7, 13), and said inverted output terminal of said first OR gate circuit (4, 11) operatively connected to the first input terminal of said wired OR gate circuit (6, 14), said inverted output terminal of said second OR gate circuit (5, 12) operatively connected to the second input terminal of said wired OR gate circuit (6, 14) and said non-inverted output terminal of said second OR gate circuit (5, 12) operatively connected to the second input terminal of said AND gate circuit (7, 13), an output terminal of said wired OR gate circuit (6, 14) and the first output terminal of said AND gate circuit (7, 13) outputting complementary signals;

a feedback line connected between the second output terminal of said AND gate circuit (7, 13) and the second input terminal of said second OR gate circuit (5, 12); and

noise resistance means (9, 20), operatively connected to said feedback line; including at least a signal delay element.

5. A latch circuit, comprising at least two gate circuits with feedback lines connecting outputs and inputs thereof, and noise resistance means connected to one of said feedback lines; characterised by the following structure:—

a first gate circuit (16) operatively connected to receive a data signal and a clock signal and having an output terminal;

a second gate circuit (17) having a first input terminal operatively connected to said output terminal of said first gate circuit (16) and having a second input terminal, and having first and second output terminals;

a third gate circuit (18) having first and second input terminals and having first and second output terminals;

a first feedback line connected between said second output terminal of said second gate circuit (17) and said second input terminal of said third gate circuit (18);

a second feedback line connected between said first output terminal of said third gate circuit (18) and said second input terminal of said second gate circuit (17); and

noise resistance means (21), operatively connected to only said first feedback line, including at least a signal delay element, for eliminating noise in said first feedback line and maintaining operation speed of said latch circuit.

6. A latch circuit according to claim 5, wherein said second gate (17) has a non-inverted output terminal.

7. A latch circuit according to claim 5 or 6, wherein one of said first and second output terminals of said third gate circuit (18) is a non-inverted output terminal.

8. A latch circuit according to any preceding claim, wherein said noise resistance circuit (8, 9) includes a filter circuit.

9. A latch circuit according to claim 8, wherein said filter circuit includes a resistor (R) and a capacitor (C) operatively connected in series with said resistor (R).

10. A latch circuit according to claim 9, or any of claims 4 to 7 as appended to claim 3, wherein said resistor is formed in a diffused region.

11. A latch circuit according to claim 10, wherein said capacitor is formed in a depletion layer adjacent to said resistor diffused region.

12. A latch circuit according to any preceding claim, wherein said noise resistance circuit includes an amplifier circuit (20, 21) including a signal delay element having a predetermined delay time and a signal amplifying element having a predetermined amplification.

13. A latch circuit according to claim 12, wehrein said amplifier circuit includes a differential amplifier.

14. A latch circuit according to claim 13, wherein said differential amplifier includes transistors.

15. A latch circuit according to any preceding claim, wherein said latch circuit is formed in a semiconductor device.

16. A latch circuit according to any preceding claim, wherein said latch circuit is formed in a bipolar-type semiconductor device.

17. A latch circuit according to any preceding claim, wherein said gate circuits are formed employing emitter-coupled logic circuitry.

## Patentansprüche

1. Verriegelungsschaltung, mit wenigstens zwei Torschaltungen mit Rückkopplungsleitungen, die deren Ausgänge und Eingänge verbinden, und mit Rauschunterdrückungseinrichtungen, die mit einer der genannten Rückkopplungsleitungen verbunden sind, gekennzeichnet durch die folgende Struktur:—
eine erste Torschaltung (3) ist wirkungsmäßig zum Empfang eines Datensignales und eines Taktsignales angeschlossen und hat einen Ausgangsanschluß;
eine zweite Torschaltung (1) hat einen ersten Eingangsanschluß, der wirkungsmäßig mit dem Ausgangsanschluß der genannten ersten Torschaltung verbunden ist, einen zweiten Eingangsanschluß und einen Ausgangsanschluß;
eine dritte Torschaltung (2) hat einen ersten Eingangsanschluß, der wirkungsmäßig verbunden ist, um ein invertiertes Taktsignal an einem Eingangsanschluß zu empfangen, einen zweiten Eingangsanschluß und erste und zweite Ausgangsanschlüsse;
eine erste Rückkopplungsleitung ist zwischen dem Ausgangsanschluß der genannten zweiten Torschaltung (1) und dem zweiten Eingangsanschluß der genannten dritten Torschaltung (2) verbunden;
eine zweite Rückkopplungsleitung ist zwischen dem ersten Ausgangsanschluß der genannten dritten Torschaltung (2) und dem zweiten Eingangsanschluß der genannten zweiten Torschaltung (1) verbunden, und der zweite Ausgangsanschluß der genannten dritten Torschaltung (2) und der Ausgangsanschluß der genannten zweiten Torschaltung (1) geben in Abhängigkeit von einem verriegelten Zustand der genannten Verriegelungsschaltung komplementäre Signale aus; und
Rauschunterdrückungseinrichtungen (8) sind wirkungsmäßig nur mit der genannten zweiten Rückkopplungsleitung verbunden und enthalten wenigstens ein Signalverzögerungselement, um Ruaschen in der genannten zweiten Rückkopplungsleitung zu eliminieren und um die Betriebsgeschwindigkeit der genannten Verriegelungsschaltung aufrecht zu erhalten.

2. Verriegelungsschaltung nach Anspruch 1, bei der die genannten ersten, zweiten und dritten Torschaltungen (1, 2, 3) NOR-Torschaltungen sind und die genannte Rückkopplungsleitung zwischen einem Ausgangsanschluß der genannten dritten Torschaltung (2) und einem Eingangsanschluß der genannten zweiten NOR-Torschaltung (1) gebildet ist.

3. Verriegelungsschaltung nach Anspruch 2, bei der die genannte dritte NOR-Torschaltung (2) erste und zweite Ausgangsanschlüsse hat, der erste Ausgangsanschluß wirkungsmäßig mit dem Eingangsanschluß der genannten zweiten NOR-Torschaltung (1) verbunden ist und der zweite Ausgangsanschluß ein Signal in Abhängigkeit von dem verrigelten Zustand der genannten Verriegelungsschaltung ausgibt.

4. Verriegelungsschaltung, mit wenigstens zwei Torschaltungen mit Rückkopplungsleitungen, die Ausgänge und Eingänge davon verbinden, und mit Rauschunterdrückungseinrichtungen, die mit einer der genannten Rückkopplungsleitungen verbunden sind, gekennzeichnet durch die folgende Struktur:—
eine erste ODER-Torschaltung (4, 11) ist wirkungsmäßig verbunden, um ein Datensignal und ein Taktsignal zu empfangen, und hat einen nicht-invertierten Ausgangsanschluß und einen invertierten Ausgangsanschluß;

# EP 0 184 350 B1

eine zweite ODER-Torschaltung (5, 12) hat einen ersten Eingangsanschluß, der wirkungsmäßig verbunden ist, um ein invertiertes Taktsignal zu empfangen, und einen zweiten Eingangsanschluß und einen nicht-invertierten Ausgangsanschluß und einen invertierten Ausgangsanschluß;

eine UND-Torschaltung (7, 13) hat erste und zweite Eingangsanschlüsse und erste und zweite Ausgangsanschlüsse;

eine verdrahtete ODER-Torschaltung (6, 14) hat erste und zweite Eingangsanschlüsse, der nicht-invertierte Ausgangsanschluß der genannten ersten ODER-Torschaltung (4, 11) ist wirkungsmäßig mit dem ersten Eingangsanschluß der genannten UND-Torschaltung (7, 13) verbunden, und der genannte invertierte Ausgangsanschluß der ersten ODER-Torschaltung (4, 11) wirkungsmäßig mit dem ersten Eingangsanschluß der genannten verdrahteten ODER-Torschaltung (6, 14) verbunden, der genannte invertierte Ausgangsanschluß der genannten zweiten ODER-Torschaltung (5, 12) ist wirkungsmäßig mit dem zweiten Eingangsanschluß der genannten verdrahteten ODER-Torschaltung (6, 14) verbunden, und der genannte nicht-invertierte Ausgangsanschluß der genannten zweiten ODER-Torschaltung (5, 12) ist wirkungsmäßig mit dem zweiten Eingangsanschluß der genannten UND-Torschaltung (7, 13) verbunden ist, und ein Ausgangsanschluß der genannten verdrahteten ODER-Torschaltung (6, 14) und der erste Ausgangsanschluß der genannten UND-Torschaltung (7, 13) geben komplementäre Signale aus;

eine Rückkopplungsleitung ist zwischem dem zweiten Ausgangsanschluß der genannten UND-Torschaltung (7, 13) und dem zweiten Eingangsanschluß der genannten ODER-Torschaltung (5, 12) verbunden; und

Rauschunterdrückungseinrichtungen (9, 20), die wirkungsmäßig mit der genannten Rückkopplungsleitung verbunden sind, enthalten wenigstens ein Signalverzögerungselement.

5. Verriegelungsschaltung mit wenigstens zwei Torschaltungen, mit Rückkopplungsleitungen, die Ausgänge und Eingänge davon verbinden, und Rauschunterdrückungseinrichtungen, die mit einer der Rückkopplungsleitungen verbunden sind, gekennzeichnet durch die folgende Struktur:—

eine erste Torschaltung (16) ist wirkungsmäßig verbunden, um ein Datensignal und ein Taktsignal zu empfangen und hat einen Ausgangsanschluß;

eine zweite Torschaltung (17) hat einen ersten Eingangsanschluß, der wirkungsmäßig mit dem genannten Ausgangsanschluß der genannten ersten Torschaltung (16) verbunden ist, und einen zweiten Eingangsanschluß und erste und zweite Ausgangsanschlüsse;

eine dritte Torschaltung (18) hat erste und zweite Eingangsanschlüsse und erste und zweite Ausgangsanschlüsse;

eine erste Rückkopplungsleitung ist zwischen dem genannten zweiten Ausgangsanschluß der genannten zweiten Torschaltung (17) und dem genannten zweiten Eingangsanschluß der genanten dritten Torschaltung (18) verbunden;

eine zweite Rückkopplungsleitung ist zwischen dem genannten ersten Ausgangsanschluß der genannten dritten Torschaltung (18) und dem genannten zweiten Eingangsanschluß der genannten zweiten Torschaltung (17) verbunden; und

Rauschunterdrückungseinrichtungen (21), die wirkungsmäßig nur mit der genannten ersten Rückkopplungsleitung verbunden sind, enthalten wenigstens ein Signalverzögerungselement, um Rauschen in der genannten ersten Rückkopplungsleitung zu eliminieren und um die Betriebsgeschwindigkeit der genannten Verriegelungsschaltung aufrecht zu erhalten.

6. Verriegelungsschaltung nach Anspruch 5, bei der das genannte zweite Tor (17) einen nicht-invertierten Ausgangsanschluß hat.

7. Verriegelungsschaltung nach Anspruch 5 oder 6, bei der einer der genannten ersten und zweiten Ausgangsanschlüsse der genannten dritten Torschaltung (18) ein nicht-invertierter Ausgangsanschluß ist.

8. Verriegelungsschaltung nach einem der vorhergehenden Ansprüche, bei der die Rauschunterdrückungsschaltung (8, 9) eine Filterschaltung enthält.

9. Verriegelungsschaltung nach Anspruch 8, bei der die genannte Filterschaltung einen Widerstand (R) und einen Kondensator (C) enthält, der wirkungsmäßig in Reihe mit dem genannten Widerstand (R) verbunden ist.

10. Verriegelungsschaltung nach Anspruch 9 oder einem der Ansprüche 4 bis 7 in Verbindung mit Anspruch 3, bei der der genannte Widerstand in einem diffundierten Bereich gebildet ist.

11. Verriegelungsschaltung nach Anspruch 10, bei der der genannte Kondensator in einer Verarmungsschicht neben dem genannten diffundierten Widerstandsbereich gebildet ist.

12. Verriegelungsschaltung nach einem der vorhergehenden Ansprüche, bei der die genannte Rauschunterdrückungsschaltung eine Verstärkerschaltung (20, 21) umfaßt, die ein Signalverzögerungselement enthält, das eine vorbestimmte Verzögerungszeit hat, und ein Signalverstärkungselement, das eine vorbestimmte Verstärkung hat.

13. Verriegelungsschaltung nach Anspruch 12, bei der die genannte Verstärkerschaltung einen Differentialverstärker umfaßt.

14. Verriegelungsschaltung nach Anspruch 13, bei der der genannte Differentialverstärker Transistoren enthält.

15. Verriegelungsschaltung nach einem der vorhergehenden Ansprüche, bei der die genannte Verriegelungsschaltung in einer Halbleitervorrichtung gebildet ist.

16. Verriegelungsschaltung nach einem der vorhergehenden Ansprüche, bei der die

11

# EP 0 184 350 B1

'Verriegelungsschaltung in einer bipolaren Halbleitervorrichtung gebildet ist.

17. Verriegelungsschaltung nach einem der vorhergehenden Ansprüche, bei der die genannten Torschaltungen unter Verwendung von emittergekoppelten Logikschaltungen gebildet sind.

## Revendications

1. Circuit à verrouillage comprenant au moins deux portes dont les entrées et les sorties sont reliées par des lignes de rétroaction, et des moyens de résistance au bruit connectés à l'une des lignes de rétroaction, caractérisé par la structure suivante:

—une première porte (3) connectée en fonctionnement de façon à recevoir un signal de données et un signal d'horloge et ayant une borne de sortie;

—une seconde porte (1) ayant une première borne d'entrée connectée en fonctionnement à la borne de sortie de ladite première porte, ayant une seconde borne d'entrée, et ayant une borne de sortie;

—une troisième porte (2) ayant une première borne d'entrée connectée en fonctionnement de façon à recevoir un signal d'horloge inversé sur une borne d'entrée et une seconde borne d'entrée, et ayant des première et seconde bornes de sortie;

—une première ligne de rétroaction connectée entre le borne de sortie de ladite seconde porte (1) et la seconde sortie de ladite troisième porte (2);

—une seconde ligne de rétroaction connectée entre la première borne de sortie de ladite troisième porte (2) et la seconde borne d'entrée de ladite seconde porte (1), la seconde borne de sortie de ladite troisième porte (2) et la borne de sortie de ladite seconde porte (1) fournissant en sortie des signaux complémentaires en réponse à un état verrouillé dudit circuit à verrouillage; et

—des moyens de résistance au bruit (8), connectés en fonctionnement uniquement à ladite seconde ligne de rétroaction et comprenant au moins un élément de retard de signal pour éliminer le bruit sur ladite seconde ligne de rétroaction et maintenir la vitesse de fonctionnement dudit circuit à verrouillage.

2. Circuit à verrouillage selon la revendication 1, dans lequel lesdites première, seconde et troisième portes (1, 2, 3) sont des portes NON OU et ladite ligne de rétroaction est formée entre une borne de sortie de ladite troisième porte NON OU (2) et une borne d'entrée de ladite seconde porte NON OU (1).

3. Circuit à verrouillage selon la revendication 2, dans lequel ladite troisième porte OU (2) a des première et seconde bornes de sortie, la première borne de sortie étant connectée en fonctionnement à la borne d'entrée de ladite seconde porte NON OU (1) et la seconde borne de sortie fournissant un signal en réponse à un état verrouillé dudit circuit à verrouillage.

4. Circuit à verrouillage comprenant au moins deux portes avec des lignes de rétroaction reliant leurs entrées et leurs sorties, et des moyens de résistance au bruit connectés à l'une desdites lignes de rétroaction; caractérisé par la structure suivante:

—une première porte OU (4, 11) connectée en fonctionnement de façon à recevoir un signal de données et un signal d'horloge, et ayant une borne de sortie non inversée et une borne de sortie inversée;

—une seconde porte OU (5, 12) ayant une première borne d'entrée connectée en fonctionnement de façon à recevoir un signal d'horloge inversé et ayant une seconde borne d'entrée, une borne de sortie non inversée et une borne de sortie inversée;

—une porte ET (7, 13) ayant des première et seconde bornes d'entrée, et des première et seconde bornes de sortie;

—une porte OU cablée (6, 14) ayant des première et seconde brones d'entrée, ladite borne de sortie non inversée de ladite première porte OU (4, 11) connectée en fonctionnement à la première borne d'entrée de ladite porte ET (7, 13), et ladite borne de sortie inversée de ladite première porte OU (4, 11) connectée en fonctionnement à la première borne d'entrée de ladite porte OU cablée (6, 14), ladite borne de sortie inversée de ladite seconde porte OU (5, 12) connectée en fonctionnement à la seconde borne d'entrée de ladite porte OU cablée (6, 14), et ladite borne de sortie non inversée de ladite seconde porte OU (5, 12) connectée en fonctionnement à la seconde borne d'entrée de ladite porte ET (7, 13), une borne de sortie de ladite porte U cablée (6, 14) et la première borne de sortie de ladite porte ET (7, 13) fournissant des signaux complémentaires de sortie;

—une ligne de rétroaction connectée entre la seconde borne de sortie de ladite porte ET (7, 13) et la seconde borne d'entrée de ladite seconde porte OU (5, 12); et

—des moyens de résistance au bruit (9, 20) connectés en fonctionnement à ladite ligne de rétroaction; comprenant au moins un élément de retard de signal.

5. Circuit à verrouillage comprenant au moins deux portes avec des lignes de rétroaction connectant leurs entrées et leurs sorties, et des moyens de résistance au bruit connectés à l'une desdites lignes de rétroaction; caractérisé par la structure suivante:

—une première porte (16) connecté en fonctionnement de façon à recevoir un signal de données et un signal d'horloge et ayant une borne de sortie;

—une seconde porte (17) ayant une première borne d'entrée connectée en fonctionnement à ladite borne de sortie de ladite première grille (16) et ayant une seconde borne d'entrée, et ayant des première et seconde bornes de sortie;

—une troisième porte (18) ayant des première et seconde bornes d'entrée et ayant des première et

12

seconde bornes de sortie;

—une première ligne de rétroaction connectée entre ladite seconde borne de sortie de ladite seconde porte (17) et ladite seconde borne d'entrée de ladite troisième porte (18);

—une seconde ligne de rétroaction connectée entre ladite première borne de sortie de ladite troisième porte (18) et ladite seconde borne d'entrée de ladite seconde porte (17); et

—des moyens de résistances au bruit (21), connectés en fonctionnement uniquement à ladite première ligne de rétroaction, comprenant au moins un élément de retard de signal pour éliminer le bruit sur ladite première ligne de rétroaction et maintenir la vitesse de fonctionnement dudit circuit à verrouillage.

6. Circuit à verrouillage selon la revendication 5, dans lequel ladite seconde porte (17) a une borne de sortie non inversée.

7. Circuit à verrouillage selon la revendication 5 ou 6, dans lequel l'une desdites première et seconde bornes de sortie de ladite troisième porte (18) est une borne de sortie non inversée.

8. Circuit à verrouillage selon l'une quelconque des revendications précédentes, dans lequel ledit circuit de résistance au bruit (8, 9) comporte un circuit de filtre.

9. Circuit à verrouillage selon la revendication 8, dans lequel ledit circuit de filtre comporte une résistance (R) et une capacité (C) connectée en fonctionnement en série avec ladite résistance (R).

10. Circuit à verrouillage selon la revendication 9, ou selon l'une des revendications 4 à 7 dépendantes de la revendication 3, dans lequel ladite résistance est constituée par une région diffusée.

11. Circuit à verrouillage selon la revendication 10, dans lequel ladite capacité est formée dans une couche à déplétion adjacente à la région diffusée de résistance.

12. Circuit à verrouillage selon l'une quelconque des revendications précédentes, dans lequel ledit circuit de résistance au bruit comporte un amplificateur (20, 21) comprenant un élément retardateur de signal ayant un retard de temps prédéterminé et un élément d'amplification du signal ayant un gain prédéterminé.

13. Circuit à verrouillage selon la revendication 12, dans lequel ledit amplificateur comporte un amplificateur différentiel.

14. Circuit à verrouillage selon la revendication 13, dans lequel ledit amplificateur différentiel comporte des transistors.

15. Circuit à verrouillage selon l'une quelconque des revendications précédentes, dans lequel ledit circuit à verrouillage est formé sur un circuit semiconducteur.

16. Circuit à verrouillage selon l'une quelconque des revendications précédentes, dans lequel ledit circuit à verrouillage est formé sur un circuit semiconducteur de type bipolaire.

17. Circuit à verrouillage selon l'une quelconque des revendications précédentes, dans lequel lesdites portes sont formées en utilisant une logique à couplage d'émetteur (ECL).

# Fig. 1

Fig.2a  CLK

Fig.2b  $\overline{CLK}$

Fig.2c  DT

Fig.2d  S3

Fig.2e  SQ

Fig.2f  $\overline{SQ}$

# Fig. 3

# Fig. 4

# Fig. 5

# Fig. 6

## Fig. 7

115  120  116  121

p

n — 106

n — 103

n⁺⁺ — 102

p — 101

## Fig. 8

123  117  122  118

p

106

n — 103

n⁺⁺ — 102

p — 101

*Fig. 9*

*Fig. 11*

*Fig. 13*

6

# Fig. 10

Fig. 12

Fig. 14